# EUROPEAN PATENT SPECIFICATION

(11) **EP 0 785 557 B1**
(45) Date of publication and mention of the grant of the patent: **20.10.1999**
(21) Application number: 96924176.9
(22) Date of filing: 22.07.1996
(51) Int. Cl.: H01F 1/37, H05K 9/00, H01Q 17/00, H01L 23/552

(54) **COMPOSITE MAGNETIC MATERIAL AND PRODUCT FOR ELIMINATING ELECTROMAGNETIC INTERFERENCE**
MAGNETISCHES KOMPOSITARTIKEL UND PRODUKT ZUR UNTERDRÜCKUNG VON ELEKTROMAGNETISCHEN INTERFERENZEN
MATERIAU MAGNETIQUE COMPOSITE ET PRODUIT POUR ELIMINER LES INTERFERENCES ELECTROMAGNETIQUES

(30) Priority: 20.07.1995 JP 18391195
(43) Date of publication of application: 23.07.1997
(73) Proprietor: TOKIN CORPORATION, Sendai-shi Miyagi-ken 982 (JP)
(72) Inventor: YOSHIDA, Shigeyoshi, Taihaku-ku, Sendai-shi Miyagi 982 (JP); SATO, Mitsuharu, Taihaku-ku, Sendai-shi Miyagi 982 (JP); SUGAWARA, Eishu,, Taihaku-ku, Sendai-shi Miyagi 982 (JP); SHIMADA, Yutaka, Aoba-ku Sendai-shi2Miyagi 981 (JP)
(74) Representative: Prüfer, Lutz H., Dipl.-Phys.
(86) International application number: JP9602040
(87) International publication number: WO9704469

(56) References cited:
- EP-A- 0 380 267
- EP-A- 0 667 643
- EP-A- 0 764 954
- JP-A- 4 108 666
- JP-A- 6 251 928
- JP-A- 7 212 079
- JP-A- 8 018 271
- US-A- 2 873 225
- JOURNAL OF APPLIED PHYSICS, vol. 75, no. 10, PART 02A, 15 May 1994, pages 6109-6111, XP000457046 KWON H J ET AL: "THE MICROWAVE ABSORBING AND RESONANCE PHENOMENA OF Y-TYPE HEXAGONAL FERRITE MICROWAVE ABSORBERS"
- JOURNAL OF APPLIED PHYSICS, vol. 76, no. 10, PART 02, 15 November 1994, pages 6570-6572, XP000508787 VIAU G ET AL: "PREPARATION AND MICROWAVE CHARACTERIZATION OF SPHERICAL AND MONODISPERSE CO20NI80 PARTICLES"
- PATENT ABSTRACTS OF JAPAN vol. 017, no. 444 (E-1415), 16 August 1993 & JP 05 095197 A (MITSUI TOATSU CHEM INC), 16 April 1993,
- PATENT ABSTRACTS OF JAPAN vol. 017, no. 214 (E-1357), 27 April 1993 & JP 04 352498 A (MITSUI TOATSU CHEM INC), 7 December 1992,

## Description

### Technical Field:

The present invention relates to composite magnetic materials comprising soft magnetic powders kneaded with and dispersed in an organic binder and, in particular, to the composite magnetic material excellent in a characteristic of complex magnetic permeability effective in suppressing an electromagnetic interference which is a problem in high frequency electronic circuits/devices, and to a method for producing the same.

The present invention further relates to electromagnetic interference suppressor members and electronic parts, such as printed circuit boards used in electronic apparatus, which use the above-mentioned composite magnetic materials.

### Background Art:

As digital electronic apparatus which have recently been widely used, there are known logic circuits or elements, such as a random access memory (RAM), a read only memory (ROM), a microprocessor unit (MPU), an image processing algebra logic unit (IPALU) or the like. The logic circuit and the logic element comprise LSI and IC including a large number of semiconductor elements of active elements and are mounted on a printed circuit board. In the logic circuit and element, executing speed and signal processing speed are increased. In such a logic circuit or the like, high-speed signals are accompanied by sudden variation of voltage and current, so that the active elements generate inductive noise which is high frequency noise. The high frequency noise cooperates with the other noise, such as crosstalk noise and impedance mismatching noise. The high frequency noise is mainly caused by the inductive noise generated by the active element. The induction noise induces a high frequency magnetic field on a surface of the printed circuit board on which the element is mounted and on the opposite surface.

In addition, electronic devices and apparatus are rapidly improved to decrease in weight, thickness, and size. Accompanying this, a density is extremely increased in mounting of electronic devices onto the printed circuit board. Since printed wires between the electronic devices mounted with high mounting density or wires between modules are placed near to each other, and since the signal processing speed is increased as described above, the induced high frequency magnetic field increases the electromagnetic coupling between wires on the printed circuit board due to radiation noise.

The radiation noise as generated is radiated through an external connection terminal outside the devices. The harmful influence to the other devices and the malfunction of the electronic apparatus are collectively called as an electromagnetic obstacle.

Against the electromagnetic obstacles radiated, countermeasure is adopted in the prior art, for example, connecting a filter to a circuit which generates the inductive noise in the electronic device, separating a circuit having a problem (which generates the inductive noise) from another circuit influenced thereby, shielding, or grounding.

In a printed circuit board or others on which electronic parts including active elements are mounted in a high density, those known countermeasure against the electromagnetic obstacle (noise suppression) has disadvantages, for example, that special knowledge and experience are required therefor and a long time is required for establishment of the countermeasure.

Particularly, the use of the filter as mentioned above has disadvantages that the filter used for removing noises is too expensive, that a space mounting the filter is often limited, that a work of mounting a filter is accompanied with a difficulty, and that many steps are required for assembling a device including the filter or the like to result in high cost.

In addition, suppression against an electromagnetic induction and interference by undesired electromagnetic wave which are generated between devices placed in the same circuit is not sufficient in the prior art.

Furthermore, for miniaturization of and lightening the electronic device, the method of removing a problem circuit is disadvantageous and it is required to remove a filter and a mounting space thereof.

When a general printed circuit board, which is used for an electronic device, is used in a low frequency band, no problem occurs because the electromagnetic coupling between signal lines, such as electromagnetic induction generated in the printed circuit board, is relatively small. However, in an elevated operating frequency, the electromagnetic coupling between the signal lines becomes higher to cause the above-mentioned problem.

Among shielding methods, as the conductive shield is one of measures against the electromagnetic interference which uses a reflection of electromagnetic wave caused by impedance mismatching with space, it can provide the shield effect, but promote an electromagnetic coupling due to the reflection of an undesired radiation so that there often causes a secondary electromagnetic interference.

For a measure against the secondary electromagnetic interferences, it is effective to use the magnetic loss of a magnetic substance to suppress the undesired radiation. That is, the undesired radiation can be suppressed by displacement of the magnetic substance having a high magnetic loss between the shield substance and the undesired radiation source. Herein, the magnetic substance has a thickness d inversely proportional to µ " in a frequency region fulfilling a relation of µ " > µ '. Therefore, a magnetic material is required which has a large complex magnetic permeability in order to obtain a thin electromagnetic interference suppressor member or a composite member comprising a shielding element and a magnetic element so as to accommodate a demand of miniaturization of and lightening of the electric device. Accordingly, it is desired for the electromagnetic interference suppressor member to deal with the undesired radiation over wide frequency.

From EP 0 380 267 A1 a non-conductive microwave absorber having at least two major components is known.

The first component is acicular magnetic metallic polycrystalline filaments having an average length of less than about 10 micron, a diameter greater than about 0.1 micron, and a length to diameter ratios between 10:1 and 50:1. The second component is a dielectric binder, in which the filaments are dispersed, and which contributes to the absorption performance of the composite absorber.

From J. Appl. Phys. 75(10), May 15, 1994, p. 6109, 6110 a Y-type hexagonal ferrite-rubber composite with two types of resonances is known.

From J. Appl. Phys. 76(1994), November 15, Part 2, No. 10, Woodbury, NY, US, p. 6570, 6571 it is known that Co₂₀Ni₈₀ particles are dispersed in an epoxy resin showing multiple resonance bands.

It is an object of the present invention to provide a composite magnetic material for use in an electromagnetic interference suppressor member effective to inhibit an electromagnetic interference within a high frequency electronic device, typically, a mobile communication device. It is another object of the present invention to provide a composite magnetic material capable of meeting a requirement of severe vibration resistance, shock resistance and adaptability for a complex shape. It is still another object of the present invention to provide a method of producing the composite magnetic material. It is yet another object of the present invention to provide the electromagnetic interference suppressor member as mentioned above. It is a further object of the present invention to provide an electronic device which has a compact size and a light weight and can inhibit effectively an electromagnetic interference by provision of the composite magnetic material. It is another object of the present invention to provide a printed circuit board which has a sufficient shield effect against the transmission of electromagnetic wave without deteriorating a shield effect of an alectromagnetic shield printed circuit board and which does not promote at least a magnetic coupling due to a reflection of an electromagnetic wave.

### Disclosure of the Invention:

According to the invention these objects are solved by an electromagnetic interference suppressor member as set forth in claim 1, by a method of producing a composite magnetic material as set forth in claim 4, a printed circuit board as set forth in claim 6, and an electronic apparatus as set forth in claim 9. Preferred developments of the invention are given in the dependent claims.

### Brief Description of the Drawings:

FIG. 1 is a cross sectional view of a part of a conventional printed circuit board;
FIG. 2 is a cross sectional view of a part of an example of a conventional electronic apparatus;
FIG. 3 is a plan view of a part of another example of the conventional electronic apparatus;
FIG. 4 is a sectional view of a part of still another example of the conventional electronic apparatus;
FIG. 5 is a schematic view of an evaluation test system for use in evaluation of electromagnetic interference suppressor member according to the present invention;
FIG. 6 is a graph illustrating a µ -f characteristic curve of a composite magnetic material of a test sample No. 1 according to the present invention;
FIG. 7 is a graph illustrating a µ-f characteristic of a composite magnetic material of another test sample 2 according to the present invention;
FIG. 8 is a graph illustrating a µ-f characteristic of a comparative sample of a conventional magnetic material;
FIG. 9 is a graph illustrating a µ-f characteristic curve of a test sample 3 of a composite magnetic material according to the present invention;
FIG. 10 is a cross sectional view illustrating a part of a printed circuit board according to a first example of the present invention;
FIG. 11 is a cross sectional view of a part of the printed circuit board according to a second example of the present invention;
FIG. 12 is a cross sectional view of a part of a printed circuit board according to a third example the present invention;
FIG. 13 is a cross sectional view of a part of an electronic apparatus according to a forth example of the present invention;
FIG. 14 is a plan view of a part of an electronic apparatus according to a fifth example of the present invention;
FIG. 15 is a cross sectional view of a part of a composite magnetic layer of FIGS. 13 and 14;
FIG. 16 is a cross sectional view of a part of an electronic apparatus according to a sixth example of the present invention; and
FIG. 17 is a cross sectional view of the composite magnetic material layer illustrated in FIG. 6.

### Best Mode for Embodying the Invention:

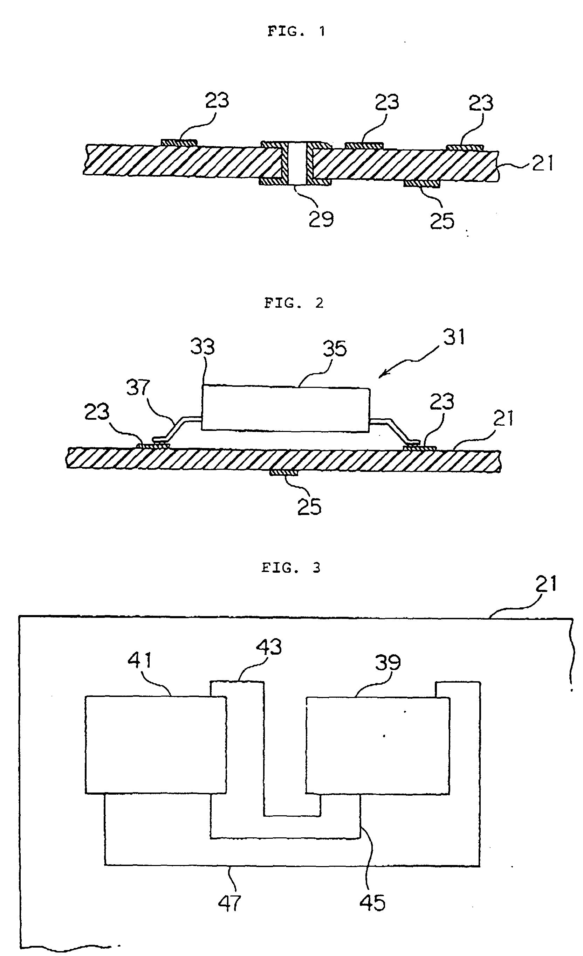

For a better understanding of this invention, description will first be made as regards a conventional printed circuit board with reference to FIG. 1.

Referring to FIG. 1, a printed circuit board 21 has circuit conductors 23 and 25 formed on both surfaces. The circuit conductors are made by printing, etching, or the like. A through hole 29 is made to connect between an upper surface and a lower surface.

Next, description will be made as regards conventional electronic apparatus with reference to FIGS. 2 to 4.

Referring to FIG. 2, an electronic apparatus 31 comprises an LSI 33 mounted on a surface of the printed circuit board 21. The LSI 33 has a LSI body 35 and contact pin terminals 37. The contact pin terminals 37 extend to conductive patterns 23, respectively, formed on the surface of the printed circuit board 21. The LSI body 35 is disposed in a floating state with a distance left between the LSI body 35 and the surface of the printed circuit board 21. A circuit conductor (pattern) 25 is wired to extend just below the LSI 33 on the printed circuit board 21.

Referring to FIG. 3, another example of an electronic apparatus has LSI's 39 and 41 mounted on the surface of the printed circuit board 21 in the similar manner being described in connection with FIG. 2. The LSI's 39 and 41 are connected with each other by circuit conductors (patterns) 43, 45, and 47 which are formed on the surface of the printed circuit board 21.

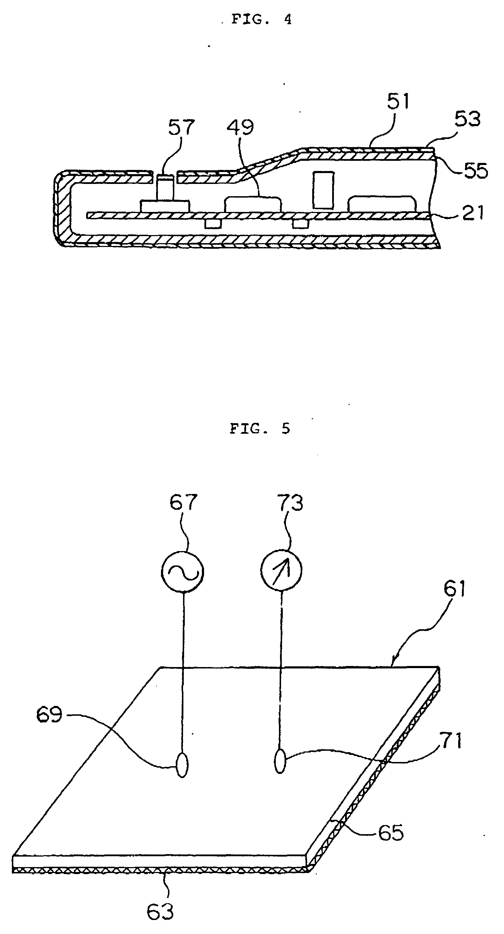

Referring to FIG. 4, the electronic device shown therein includes a printed circuit board 21 supporting thereon, an electronic part 49 of an active element radiating an induction noise, and a case 51 as a storage body covering all over the printed circuit board 21. The case 51 has a shell portion 53 made of resin and a conductive layer 55 formed by applying a conductive paste inside the shell portion 53. In the case 51, mechanical parts 57 are mounted on the printed circuit board 21 in addition to the electronic part 49.

Description will be made as regards an electronic interference suppressor member, a composite magnetic material, and a method of producing them with reference to FIGS. 5 to 10.

In order to obtain a composite magnetic material which has an anisotropic magnetic field (Hk) with a desired strength corresponding to a desired magnetic loss characteristic, soft magnetic powder may be used which has at least one anisotropy selected from the group consisting of a shape magnetic anisotropy, a crystalline magnetic anisotropy, an inductive magnetic anisotropy, and a magnetic elastic effect (magnetostrictive effect). That is, in the present invention, a plurality of magnetic powders may be mixed which have anisotropic magnetic fields (Hk) different in strength from each other in order to obtain a plurality of magnetic resonances which are different from each other and a magnetic loss of an expanded band corresponding to the magnetic resonances.

As means to obtain a plurality of magnetic resonances other than those described above, it is possible to positively use specific properties of a powder and a composite powder or processes of grinding and rolling, which will be mentioned below.

A first means is to use a differentiation of properties of the powder which is obtained from processing a single kind of raw material under a specific condition. A second means is to positively use a contamination phenomenon in the grinding and rolling processes of the powder by the use of soft magnetic media such as steel balls as grinding media, where soft magnetic powder made by abrasion of the media is mixed into the processed powder. A third means is to use different existent forms of a single kind of powder in the composite materials. For example, anisotropic magnetic fields are dispersed because magnetic interaction and orientation behaviors are different between particle groups. One group particles are dispersed in a same matrix as primary particles. The other group particles aggregate to come into contact with or to be close to each other because of insufficient internal wet.

Furthermore, if a sample particle has a thin shape or a sheet shape, an effective anisotropic magnetic field is defined as an algebraic sum with a demagnetizing field. Therefore, an orientation control of raw magnetic powder can be positively used.

In the present invention, any one of those means described above can be used to obtain a plurality of anisotropic magnetic fields. It is important to give a plurality of anisotropic magnetic fields so as to obtain a desired magnetic loss band. Particularly, an anisotropic magnetic field which gives a magnetic resonance at the lowest frequency is required to be set at a value which gives a magnetic resonance in a frequency region lower than a lower limit of a desired electromagnetic interference suppressing frequency band, considering that a dispersion of imaginary permeability (magnetic loss) occurs depending on decrease of real permeability.

The soft magnetic powder used in the present invention may typically be a powder which is obtained by grinding, drawing, tearing, or atomize-corning of soft magnetic metal with high permeability in a high frequency region, for example, iron-aluminium-silicon alloy (i.e. Sendust), iron-nickel alloy (i.e. permalloy), amorphous alloy, or the like. It is preferable that the powder is at least oxidized at the surface to electrically insulate particles of powder from each other so as to ensure non-conductivity of the composite magnetic material, which is an essential condition according to the present invention, in a state of highly packed powders.

As other soft magnetic powder used in the present invention, a soft magnetic oxide material, such as a spinel type ferrite, a planar type ferrite, or the like can be used, and use can also be made of a mixture with the soft magnetic metal as described above.

Furthermore, the organic binder used as another ingredient in the present invention may be a thermoplastic resin such as polyester resin, poly ethylene resin, polyvinyl chloride resin, polyvinyl butyral resin, polyurethane resin, ABS resin, nitrile-butadiene rubber, and stylene-butadiene rubber, and copolymers thereof, or a thermosetting resin such as epoxy resin, phenol aldehyde resin, amide series resin, imide resin, or the like.

For kneading and dispersing the components of the present invention, any means can not be limited as far as they are selectively used on the base of properties of the organic binder or an easiness of producing steps.

The electromagnetic interference suppressor member and the composite magnetic material of the present invention have a plurality of anisotropic magnetic fields (Hk) different in strength from each other, accordingly, a plurality of magnetic resonances being generated in frequency regions different from each other. In this event, the imaginary permeabilities µ'' are combined which are present in frequency regions different from each other due to the plurality of magnetic resonances, so that a characteristic of µ'' is obtained which is distributed over a wide frequency band. The imaginary pemeability µ'' is a part representing the magnetic loss which is required for absorbing an electromagnetic wave. A large value of µ'' and a wide frequency region realize a superior electromagnetic interference suppressing effect.

Furthermore, the soft magnetic powder used in the present invention has at least oxidized surfaces so that individual particles are electrically insulated even in a highly packed ratio, and is therefore little in not only degradation of the frequency characteristic due to the eddy current loss, which can be seen in a conductive bulk material, but also a surface reflection of the electromagnetic wave due to the impedance mismatching with a space, to thereby realize a superior effect of the electromagnetic interference suppression in a high frequency region.

The electromagnetic interference suppressor member of the present invention will be more concretely described as follows.

First, description will be made as regards an example of a method of producing the composite magnetic material and the soft magnetic powder as a raw material thereof, which are used for the electromagnetic interference suppressor member of the present invention.

At first, a plurality of iron-aluminum-silicon alloy powders are prepared by the water-atomizing process to have different mean particle diameters, then spread and ground under various conditions by use of an attoritor and a pinmill, then put into and stirred in an organic solvent of hydrocarbon while introducing nitrogen-oxygen gas mixture with an oxygen partial pressure of 35% for 8 hours for a liquid-phase-slow-oxidation treatment, thereafter, classified to obtain resultant powders each of which has anisotropic magnetic fields different from each other. As a result of surface analyzing of the resultant powders, Al-O and Si-O bonds were clearly observed, that is, it was confirmed that oxide film is present on the surface of the powder samples.

Other sample powders were prepared by drying the spread and torn iron-aluminium-silicon alloy powders in an atmosphere of a reduced pressure and then vapor-phase-slow-oxidizing them in a nitrogen-oxygen gas mixture with oxygen partial pressure of 20 %, and were also confirmed to have Al-O and Si-O bonds in the surface layers. Thus, it is noted that the surface oxidized soft magnetic powder useful in the present invention can be produced through not only the liquid-phase-slow-oxidation process but also gas-phase-slow-oxidation-process.

### (Sample 1)

A soft magnetic paste as shown in Table 1 below was prepared and formed into a film by the doctor blade method, then the film was hot-pressed and cured at 85°C for 24 hours to obtain a test sample 1.

The test sample 1 was analyzed by a vibrating magnetometer and a scanning electron microscope, and it was thereby confirmed that its magnetization easy axis and a particle orientation were in a direction of the film surface of the test sample.

**TABLE 1**

| Component | Mixing Ratio |
|---|---|
| Flat Soft Magnetic Fine Powder (Fe-Al-Si Alloy) Fine Powder A Anisotropic Magnetic Field (Hk): 30Oe | 60 weight parts |
| Flat Soft Magnetic Fine Powder (Fe-Al-Si Alloy) Fine Powder B Anisotropic Magnetic Field (Hk): 135Oe | 35 weight parts |
| Polyurethane Resin | 8 weight parts |
| Hardening Agent (Isocyanate Compound) | 2 weight parts |
| Solvent (Mixture of Cyclohexanone and Toluene) | 40 weight parts |
| Total | 145 weight parts |

For evaluating properties for the electromagnetic interference suppressor member, measurement was performed as regards a µ-f characteristic and the electromagnetic interference suppressing effect of the test sample.

For measurement of µ-f characteristic, a sample of composite magnetic material was prepared which was worked into a toroidal shape. The sample was inserted in a test fixture which forms an one-turn coil and was subjected to an impedance measurement from which µ' and µ'' were obtained.

On the other hand, the evaluation of the electromagnetic interference suppressing effect was carried out in an evaluation system shown in FIG. 5. As a test sample of the electromagnetic interference suppressor member 61, a composite magnetic material 65 was used which had a thickness of 2 mm and each side length of 20 cm and was backed with a copper plate 63. Using an oscillator for electromagnetic wave source 67, electromagnetic field radiating and receiving small loop antennas 69 and 71 having a loop diameter of 1.5 mm were used for a wave source element and a receiving element. For measurement of a coupling level, a network analyzer (an electromagnetic strength measuring instrument) 73 was used.

### (Sample 2)

A soft magnetic paste as shown in Table 2 was prepared from which a test sample 2 was produced in the manner similar to the sample 1.

The test sample 2 was analyzed by a vibrating magnetometer and a scanning electron microscope, and it was thereby confirmed that its magnetization easy axis and particle orientation were in a direction of the film surface of the test sample.

**TABLE 2**

| Component | Mixing Ratio |
|---|---|
| Flat Soft Magnetic Fine Powder (Fe-Al-Si Alloy) Fine Powder C Anisotropic Magnetic Field (Hk): 35Oe | 30 weight parts |
| Flat Soft Magnetic Fine Powder (Fe-Al-Si Alloy) Fine Powder B Anisotropic Magnetic Field (Hk): 170Oc | 65 weight parts |
| Polyurethane Resin | 8 weight parts |
| Hardening Agent (Isocyanate Compound) | 2 weight parts |
| Solvent (Mixture of Cyclohexanone and Toluene) | 40 weight parts |
| Total | 145 weight parts |

### (Comparative sample)

A soft magnetic paste as shown in Table 3 below was prepared from which a comparative sample was obtained in the manner similar to sample 1.

The comparative sample was analyzed by a vibrating magnetometer and a scanning electron microscope, and was confirmed to be magnetically isotropic.

**TABLE 3**

| Component | Mixing Ratio |
|---|---|
| Flat Soft Magnetic Fine Powder (Fe-Al-Si Alloy) Fine Powder E Anisotropic Magnetic Field (Hk): 20Oe | 30 weight parts |
| Polyurethane Resin | 8 weight parts |
| Hardening Agent (Isocyanate Compound) | 2 weight parts |
| Solvent (Mixture of Cyclohexanone and Toluene) | 40 weight parts |
| Total | 80 weight parts |

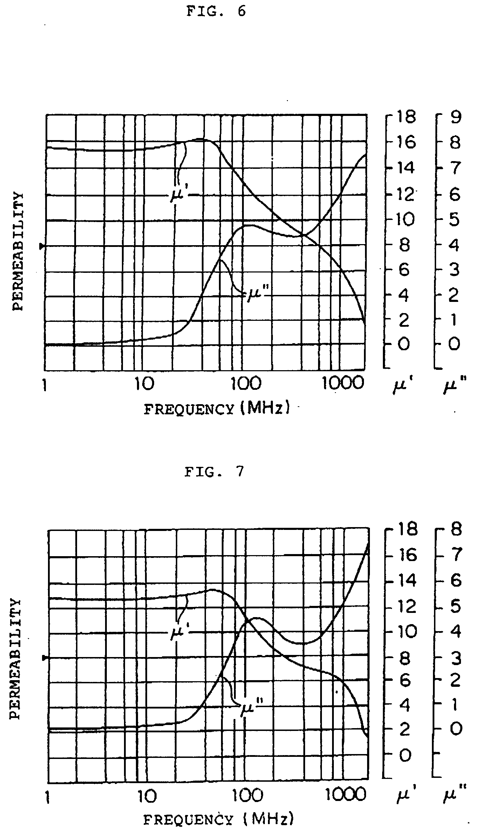

The measured µ-f characteristics of the test samples 1 and 2, and comparative sample are shown in FIGS. 6-8.

Referring to FIGS. 6 and 7 showing µ-f characteristics of test samples 1 and 2 of the present invention, respectively, it is understood that the test samples have large values of µ'' over a wide band in a high frequency region.

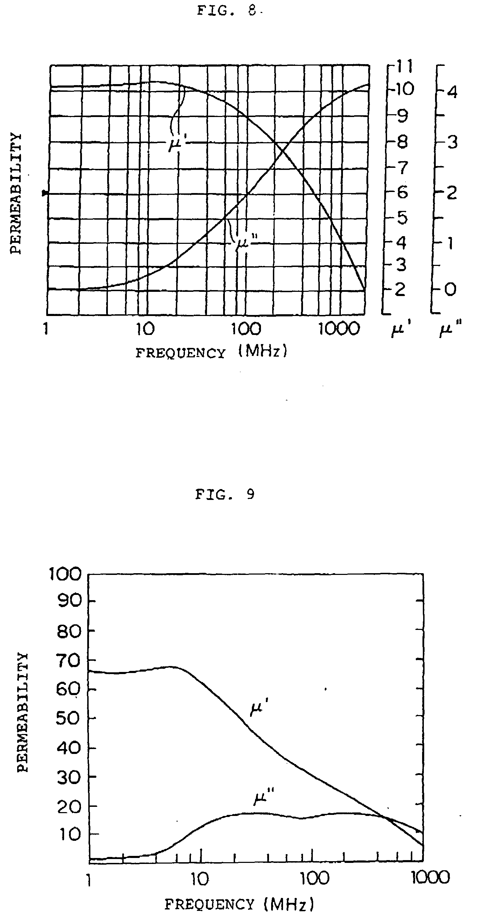

On the other hand, the known comparative sample as shown in FIG. 8 as a comparative sample has a non-wide range of the µ'' distribution which composite magnetic materials generally have.

It will be understood from those results that test samples 1 and 2 of the present invention have a magnetic loss characteristics over a wide band in a high frequency region.

Table 4 shows the powder packing ratio, the surface resistance, the µ'' distribution, and electromagnetic interference suppressing effect of each of those samples. Herein, the surface resistance is a value measured by ASTM-D-257 method, and the electromagnetic interference suppressing effect is represented by a signal attenuation value on the base of a copper plate as a reference (0 dB).

Table 4 teaches the effect as described below.

Test samples 1 and 2, and comparative sample have surface resistance values of 10⁷ to 10⁸ Ω, and this means that the composite magnetic material is made non-conductive by the use of the magnetic powder having at least oxidized surface and can suppress the surface reflection of the electromagnetic wave due to the impedance mismatching in use of the conductive material or a bulk of magnetic metal.

Moreover, although each of test samples 1 and 2 is lower than the comparative sample in the packing ratio, it is excellent in the electromagnetic interference suppressing effect. Therefore, it is understood that the extended effect of µ'' distribution in the present invention is very effective for the electromagnetic interference suppression.

**Table 4**

| | | Sample 1 | Sample 2 | Comparative Sample |
|---|---|---|---|---|
| Packing Ratio | | 38% | 33% | 55% |
| Surface Resistivity | | 7 × 10⁷Ω | 9 × 10⁷Ω | 4 × 10⁷Ω |
| µ'' Distribution | | wide | wide | narrow |
| Signal Attenuation | 800 MHz | 7.0dB | 6.5dB | 4.0dB |
| | 1.5 GHz | 8.0dB | 7.5dB | 4.5dB |

In addition, surface-oxidation of the soft magnetic materials used in the present invention brings about other effects than that as described above.

For example, by control of powder surface oxide layer in thickness, a magnetic layer can be varied in thickness so that it is possible to control a value of the anisotropic magnetic field (Hk).

### (Sample 3)

A soft magnetic paste as shown in table 5 below was prepared and formed into a film by the doctor blade method, then the film was hot pressed and cured at 85 ^{o}C for 24 hours to obtain a test sample 3. In the manner similar to test sample 1, the test sample 3 was subjected to a measurement of µ-f characteristics, and the result obtained is shown in FIG. 9. In addition, the test sample 3 was analyzed by a scanning electron microscope and it was thereby confirmed that a particle orientation was in a direction of the film surface of the test sample.

**Table 5**

| Component | Mixing Ratio |
|---|---|
| Flat Soft Magnetic (Fe-Al-Si Alloy) Fine Powder F | 90 weight parts |
| Mean Particle Size: 45 µm × 0.5 µmP | |
| Strength of Magnetostriction: +0.93 | |
| Annealing Treatment: 650°C × 2hr | |
| Flat Soft Magnetic (Fe-Al-Si Alloy) Fine Powder B | 10 weight parts |
| Mean Particle Size: 20 µm × 0.3 µm | |
| Strength of Magnetostriction: +0.72 | |
| Annealing Treatment: 650°C × 2hr | |
| Polyurethane Resin | 8 weight parts |
| Hardening Agent (Isocyanate Compound) | 2 weight parts |
| Solvent (Mixture of Cyclohexanone and Toluene) | 40 weight parts |

As mentioned above, the composite magnetic material according to the present invention and the electromagnetic interference suppressor member using the same have a plurality of anisotropic magnetic fields (Hk) different from each other to thereby cause a plurality of magnetic resonances in different frequency regions so that the µ'' distribution can be obtained in a wide band. Since the imaginary permeability µ'' is a term of the magnetic loss required to absorption of the electromagnetic wave, the excellent electromagnetic interference suppressing effect is brought about by the large value of µ " over the wide band. As a result, the electromagnetic interference suppressing member of a thin film can be obtained which is effective for suppressing interference of the electromagnetic waves within high frequency electronic devices including mobile communication terminals.

Furthermore, the composite magnetic material and the electromagnetic interference suppressor member using the same of the present invention can easily be provided with flexibility as will be easily understood from their structures, so that it is possible to deal with a complex shape and severe vibration or shock proof.

Now, description will be made as regards examples of electromagnetic interference members using the composite magnetic material according to the present invention.

### (Examples applied to a printed circuit board)

### First Example

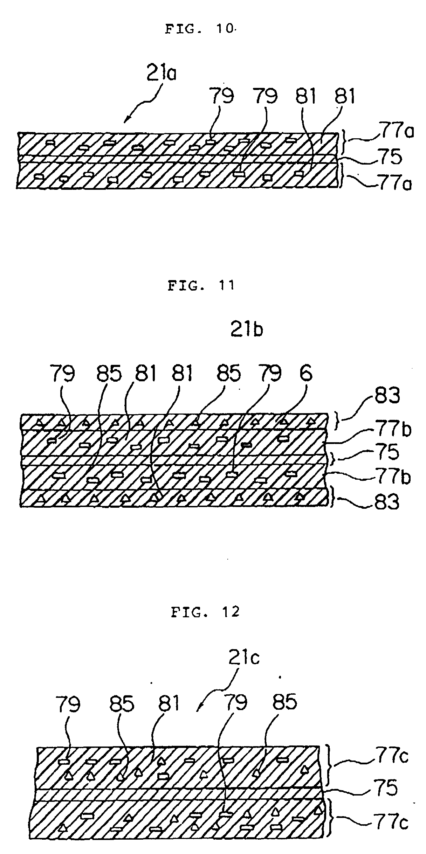

Referring to FIG. 10, a printed circuit board is used which is applied with the electromagnetic interference suppressor member using the composite magnetic material of the present invention. The printed circuit board are provided with the conductive circuit patterns 23, 25 and others thereon, which are omitted in the figure, in the similar manner as the conventional printed circuit board shown in FIG. 1.

The printed circuit board 21a of a first example, itself, has a different structure from the conventional one. That is, the first example of the printed circuit board 21a has a conductive support plate or a conductive soft magnetic support plate 75 with soft magnetism. The printed circuit board 21a, further, has a pair of insulating soft magnetic layers 77a on both sides of the conductive support plate 75. The insulating soft magnetic layer 77a comprises soft magnetic powder particles 79 and an organic binder 81. The soft magnetic powder particles 79 have flat particle shape as shown in Table 1 and have anisotropic magnetic fields different from each other. The organic binder is contained for forming a matrix of the insulating soft magnetic layer 77a.

### Second Example

Referring to FIG. 11, a second example of the printed circuit board comprises a conductive support plate 75 and insulating soft magnetic layers 77b formed on both sides of the conductive support plate 75. The printed circuit board 21b further has a pair of dielectric layers 83 on both sides of the insulating soft magnetic layers 77b in a different structure from that shown in FIG. 10. Accordingly, the second example of the printed circuit board has a structure wherein insulating soft magnetic layers 77b are interposed between the conductive support plate 75 and each of dielectric layer 83. The insulating soft magnetic layer 77b is similar to the first example and contains soft magnetic powders of the flat particle shape which have different anisotropic magnetic fields. Furthermore, the insulating soft magnetic layer 77b also contains an organic binder 81 forming its matrix. Each of the dielectric layers 83 comprises a dielectric powder 85 and an organic binder 81. The organic binder 81 is contained for forming a matrix of each of the dielectric layers 83.

### Third Example

Referring to FIG. 12, a third example of the printed circuit board comprises a conductive support layer 75 and insulating soft magnetic layers 77c formed on both sides of the conductive support layer 75. Each of the insulating soft magnetic layers 77c contains a soft magnetic powder 79 of a flat particle shape of two kinds of powder having different anisotropic magnetic fields in a similar manner to the first and the second examples. The insulating soft magnetic layer 77c also contains a dielectric powder 85 and an organic binder 81.

In the first to the third examples as mentioned above, the conductive support plate or conductive soft magnetic support plate 75 may be, for example, a conductive plate, a conductive mesh plate, or a woven fabric of conductive fibers. The conductive soft magnetic support plate 75 may be, for example, a metal plate such as a copper thin plate, stainless steel thin plate, aluminum thin plate and others, or a so called punched metal plate having fine holes formed in them, an expanded metal plate formed by fine-slitting a thin plate and then expanding it, or a metallic netting plate formed by weaving thin metallic wires into a net.

In the same system, if the material is replaced by soft magnetic permalloy or iron-silicate steel, it is expected to improve electromagnetic interference suppressing effect in a relatively low frequency region. Therefore, selection should be carried out in dependence of the use.

On the other hand, the conductive support body 75 (or conductive soft magnetic support body) can be a sheet made from a metallic powder such as silver, copper, permalloy, silicon-steel, and others, a conductive carbon black, or conductive titanium oxide, kneaded with and dispersed into organic binder 81, or, alternatively, a film, without forming sheet, formed on the one or both surfaces of an insulating substrate such as polyimide substrate by means of the doctor blade treatment, a gravure coating, a reverse coating or the like. Furthermore, the conductive support layer 75 may be one in which a conductive layer or a conductive soft magnetic layer is formed on one or both surfaces by evaporation or plating.

Moreover, the dielectric powder 85 used for forming the dielectric layer 83 or the soft magnetic layer 77c is preferably one which has a high dielectric coefficient in a high-frequency region and has a relatively flat frequency response of the dielectric characteristic. Typical examples are preferable barium titanate ceramics, zirconium titanate ceramics, and lead perovskite ceramics.

As the two kinds of flat soft magnetic powder 79 having different anisotropic magnetic fields from each other in strength, the ones shown in Tables 2 and 4 can also be used as well as one shown in Table 1.

As the organic binder 81 used for forming the insulating soft magnetic layers 77a, 77b, and 77c, use can be made of a thermoplastic resin such as polyester resin, polyvinyl chloride resin, polyvinyl butyral resin, polyurethane resin, cellulose resin, nitrile-butadiene rubber, or stylene-butadiene rubber, or copolymers thereof, or a thermosetting resin such as epoxy resin, phenol resin, amide resin, and imide resin.

Furthermore, as a reinforcement materials of the printed circuit board, use is made of a paper base materials such as linters paper, kraft paper, or the like, a glass base materials such as glass cloth, glass mat, glass paper, quartz fiber or the like, and a plastic fiber substrate such as polyester fiber, amide fiber or the like, from which selection should preferably be made considering the electric or other characteristics.

As will be understood from the components, the printed circuit board of the present invention can easily be provided with flexibility to thereby deal with a complex shape form.

As described above, it is possible according to this invention to provide a highly reliable printed wiring board which has electromagnetic wave shielding effect and electromagnetic wave absorption effect and which can suppress the influence of the external electromagnetic wave and radiation of the electromagnetic wave from the circuit.

The printed circuit board of the present invention is a printed circuit board having a structure where insulating soft magnetic layers are formed on both sides of a conductive support plate, on which wiring conductive patterns are formed. In another printed circuit board of the present invention, insulating soft magnetic layers are formed on both sides of the conductive support plate and a dielectric layer is formed on at least one surface of those insulating soft magnetic layers to form the printed circuit board on which the wiring conductive patterns are formed.

In detail, the conductive support plate which forms a part of the printed circuit board functions the shielding effect similar to the electromagnetic wave shielding circuit board substrate at a surface opposing a surface of the circuit board which plays a part of the noise source, and therefore, the electromagnetic interference can be suppressed. Further, a secondary electromagnetic coupling due to undesired radiation, generated by reflection which is caused at the side of the printed circuit board which has a noise source is suppressed by the insulating soft magnetic layer which comprises a soft magnetic powder and organic coupling agent. Further, the soft magnetic powder has the flat shape, so that the shape magnetic anisotropy occurs to thereby increase of the complex magnetic permeability based on the magnetic resonance within the high frequency region. Moreover, the soft magnetic powder is flat and, therefore, the shape magnetic anisotropy occurs and the complex permeability due to the magnetic resonance is increased in the high frequency region, so that the undesired radiation can be effectively absorbed and suppressed. The insulating soft magnetic layer can be made from a conductive soft magnetic metal by grinding into fine powder and then kneading with and dispersed into a insulating organic coupling agent to form an insulating layer. Further, the mixture of the insulating powder with the insulating soft magnetic material enables to realizes the impedance matching with the space, so that the reflection can be suppressed on the surface of the insulating soft magnetic layer.

### (Examples applied to electronic apparatus)

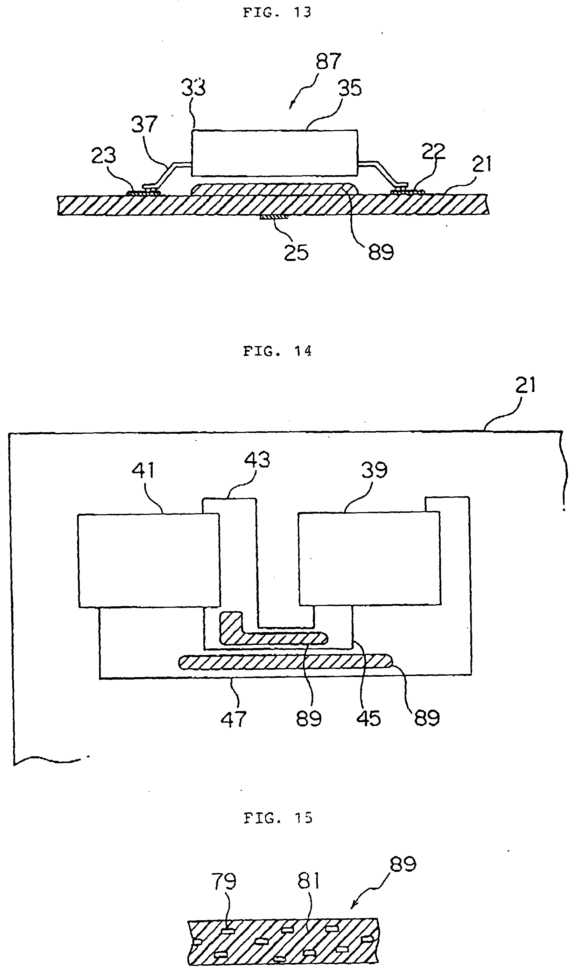

Next, description will be made as regards examples applied to electronic devices of electromagnetic wave suppressor member according to the present invention with reference to FIGS. 13 to 15.

### (Fourth Example)

Referring to FIG. 13, an electronic apparatus 87 of a fourth example differs from the conventional one shown in FIG. 1 in the following point. Between the surface of the printed circuit board 21 and the undersurface of LSI device 35, an insulating soft magnetic layer 89 is printed on the surface of the printed circuit board 25. In the forth embodiment shown in FIG. 13, the insulating soft magnetic layer 89 is located just below the LSI device 35. The insulating soft magnetic layer 89 has the same area as the LSI device 35.

When the insulating soft magnetic layer 89 is mounted as described above, the insulating soft magnetic layer 89 collects magnetic fluxes due to high frequency electromagnetic fields generated by the LSI 35. As a result, an inductive coupling between the LSI 43 and the printed circuit board 1 is decreased so that noise can effectively be suppressed.

### (Fifth Example)

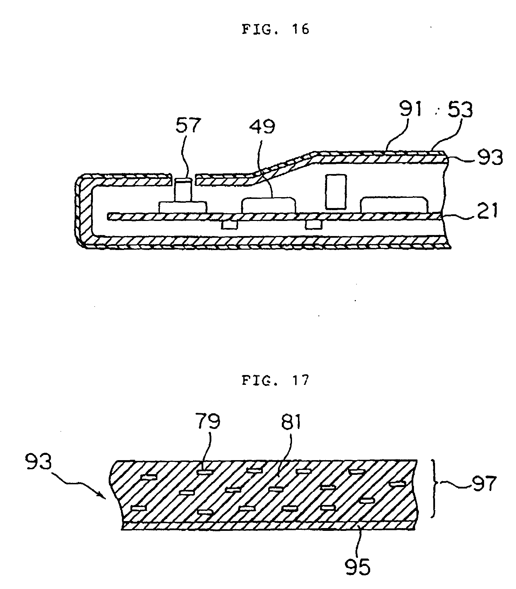

Referring to FIG. 14, an electronic apparatus of a fifth embodiment has the structure almost similar to the conventional one in FIG. 3, but the electronic apparatus differs from the conventional one in the following point.

On the surface of the printed circuit board 21, the insulating soft magnetic layers 89 are printed between the circuit conductors 43 and 45 and between the circuit conductors 45 and 47, respectively. As described in conjunction with FIGS. 2 and 3, the insulating soft magnetic layers 89 attract magnetic fluxes of high frequency wave electromagnetic fields generated from the circuit conductors 43, 45, and 47. As a result, a crosstalk among the circuit conductors 43, 45, and 47 are suppressed.

The insulating soft magnetic layer 89 will be described in detail with reference to the FIG. 15. As shown in FIG. 15, the insulating soft magnetic layer 89 comprises a soft magnetic powder 79 and an organic binder 81. In detail, the soft magnetic powder 79 is homogeneously dispersed into the organic binder 81 as shown in the figure. Herein, the soft magnetic powder 79 comprises two kinds of powder having different anisotropic magnetic fields which are in a flat shape.

For the soft magnetic powder 79, use is made of a powder shown in Tables 1, 2, and 4. The organic binder 81 may be a thermoplastic resin such as polyester resin, polyvinyl chloride resin, polyvinyl butyral resin, polyurethane resin, cellulose resin, nitrile-butadiene rubber, styrene-butadiene rubber or copolymers thereof, and a thermosetting resin such as epoxy resin, phenol resin, amide resin, or imide resin.

An example of producing the above-described electronic device will be described in the simple manner.

On a part of the circuit board on which an active element is mounted and on another part of the circuit board between the circuit conductors in parallel to each other, the soft magnetic paste shown in Table 1 was printed, thereafter dried and cured. As a result, the insulating soft magnetic layers 89 were formed with a thickness of 0.3 mm on the printed circuit board. The insulating soft magnetic layer 89 is analyzed by use of a vibrating magnetometer and a scanning electron microscope, and it was thereby confirmed that the magnetization easy axis and the magnetic particle orientation are in a direction of a surface of the sample. On the printed circuit board with the insulating magnetic layers thus formed, the electronic parts were mounted to form a circuit which was, in turn, operated. In the condition, a strength of an electromagnetic field was measured under the printed circuit board by the spectrum analyzer to confirm a suppressing effect of an electromagnetic interference. As a result, it was understood that the use of printed circuit board with the insulating soft magnetic layers 89 suppresses an electromagnetic field over a wide band at an opposite side of the printed circuit board with active element (LSI) mounted, as well as reduces a crosstalk between conductors adjacent to each other.

Thus, the electromagnetic interference can effectively he suppressed by locating the insulating magnetic layer on a part of the circuit board where a problem of undesired radiation occurs.

In addition, it will be noted from the above-described examples of the present invention that a flexibility can be given to the insulating soft magnetic layer so as to enable to deform into a complex shape as well as resist against mechanical shock.

By forming the insulating soft magnetic layer between the active element and the printed circuit board and by forming the insulating soft magnetic layer between the wiring conductors, increase of an electromagnetic coupling due to undesired radiation is suppressed by the insulating soft magnetic layers. Herein, the insulating soft magnetic layer is non-conductive by grinding soft magnetic metal which is conductive, surface-oxidizing, and dispersing into an organic binder. The soft magnetic powder is in flat particle shape and thereby has a shape magnetic anisotropy, so that the complex permeability increases due to magnetic resonances over a high frequency region to thereby effectively absorb and suppress an undesired radiation component of electromagnetic wave.

In the present invention, the insulating soft magnetic materials are disposed between the active element as a noise source and the printed circuit board and also the insulating soft magnetic materials are, if desired, disposed between the circuit conductors, as described above, so that a mutual interference caused by an electromagnetic induction and an undesired electromagnetic wave are effectively suppressed without use of filters or the like to thereby enable to advantageously realize miniatuarization and weight-lightening. As a result, an electromagnetic interference can be suppressed in high frequency devices including mobile communication terminals.

### (Sixth Example)

Referring to FIG.16, the electronic apparatus shown therein has the structure similar to the conventional electronic apparatus shown in FIG. 4 except a structural difference of the case. In detail, the case 91 has an electromagnetic interference suppressor member 93 inside the outer shell 53. In the electronic device, the electronic interference suppressor member 93 has a thickness of 0.5mm.

In the electronic apparatus, electromagnetic interference suppressor member 93 attracts magnetic fluxes due to a high frequency electromagnetic field generated by an electronic part 49 and reduces an outward radiation noise and/or an induction coupling to the other electronic parts mounted adjacent to each other on the printed circuit board 21 to suppress generation of an induction noise which is an undesired electromagnetic radiation. As a result, a mutual interference between the parts and a magnetic induction between power lines and signal lines are restrained in the circuit on the printed circuit board 21 to prevent an electromagnetic obstacle such as erroneous operation.

FIG. 17 is a partially cross sectional view of a basic structure of the electromagnetic interference suppressor member 93. The electromagnetic interference suppressor member 93 comprises a conductive or insulating support 95 and an insulating soft magnetic layer 97. The insulating soft magnetic layer 97 comprises an organic binder 81 and a soft magnetic powder 79 dispersed in the organic binder 81 which powder consists of two kinds of powder having anisotropic magnetic fields different from each other. The soft magnetic powder 79 is homogeneously dispersed into the organic binder 81, as shown in the figure.

In the electromagnetic interference suppressor member 93, when the support body 95 is conductive, the support body 95 may be one selected from the group of a conductive plate, a conductive netting plate, and a conductive fiber textiles. In the case, it is preferable that the case 91 may be formed of a non-metallic material, such as resin or the other.

On the other hand, when the support body 95 is of insulator in the electromagnetic interference suppressing substance 93, the support body 95 may be one selected from the group of an insulating plate, a insulating netting plate, and an insulating fiber textiles. In this case, it is preferable that the case 91 may be formed of metallic material, coated with a conductive paint, or formed with a conductive film by vaporizing deposition.

For the soft magnetic powder 79, use will be made of one shown in Tables 1, 2, and 4.

Furthermore, for the organic binder 81, use of made of a thermal plastic resin such as polyester resin, polyvinylf chloride, polybutyral resin, polyurethane resin, cellulose resin, nitrile-butadiene resin series rubber, and styrene-butadiene series rubber, and copolymers thereof, or a thermosetting resins such as epoxy resin, phenol resin, amide series resin, imide-series resin or the like.

In the electronic device as mentioned above, an induction noise is restrained between a mount portion mounting an active element radiating the inductive noise and a housing body wrapping the mount portion, by the electromagnetic interference suppressor member comprising the support and the insulating soft magnetic material. Therefore, suppression is performed of a radiation noise radiating from the mount portion, a mutual interference between the parts in the circuit on the mount portion (printed circuit board), and an electromagnetic induction between power lines and signal lines, so that electromagnetic obstacle such as erroneous operation can be removed.

Furthermore, in the electronic apparatus, an insulating soft magnetic substance of the electromagnetic interference suppressor member comprises an organic binder and two kinds of flat soft magnetic powder being dispersed into the organic binder and having anisotropic magnetic fields different from each other, while the support body of the electromagnetic interference suppressor member is made of an insulator or a conductor. Therefore, a great permeable attenuation can be ensured without increase of a reflection of undesired radiation caused by insertion of conductor. In addition, the electromagnetic interference suppressor member is a thin plate, so that, in comparison with the prior art, miniatuarization and light-weight can be realized as a whole of the apparatus including parts in suppression of noise, with a reduced cost. Furthermore, the electromagnetic interference suppressor member is easily given flexibility in view of the structure, to thereby be easily deformable into a complex shape and to be usable under a condition of heavy vibration and shock to be extremely excellent in applicability. Accordingly, the electronic apparatus including the mobile communication terminals can stably suppress the electromagnetic interference even in use under a heavy environment and condition, and is, therefore, improved in usefullness.

### Industrial Applicability:

As mentioned above, the composite magnetic material of the present invention is used for an electromagnetic interference suppressor member and is most useful for reduction of noises in a printed circuit board for electric parts and in electronic parts using a printed circuit board having active elements mounted thereon.

## Claims

1. An electromagnetic interference suppressor member (61,93) comprising a composite magnetic material (65), said composite magnetic material (65) consisting essentially of soft magnetic flakes (79) and an organic binder (81), said composite magnetic material (65) having electrical non-conductivity and having at least two magnetic resonances in frequency regions different from each other.

2. An electromagnetic interference suppressor member as claimed in claim 1, wherein said at least two magnetic resonances are represented in a frequency region of 1 to 2000 MHz.

3. An electromagnetic interference suppressor member as claimed in claim 2, wherein said soft magnetic flakes (79) are mixture of at least two kinds of soft magnetic flakes having different anisotropy in strength from each other and each of said at least two kinds of soft magnetic flakes (79) has surface oxide layer.

4. A method of producing a composite magnetic material (65) comprising the steps cf, mixing at least two kinds of soft magnetic flakes (79) having the magnetic anisotropy different in strength from each other and an organic binder (81), and shaping the mixture to produce said composite magnetic material (65) which is electrically non-conductive and has at least two magnetic resonances different from each other.

5. A method as claimed in claim 4, further comprising a step of oxidizing said soft magnetic flakes (79) in a gas atmosphere containing oxygen by the use of a process of vapor-phase-slow-oxidation before or during the step of the mixing said soft magnetic flakes (79) with said organic binder (81), preferably each of said soft magnetic flakes powder (79) has surface oxide layer.

6. A printed circuit board (21, 2ia, 21b, 21c) comprising a printed wiring substrate, wiring conductors on at least one surface thereof, a conductive support (75) and layers (77a, 77b, 77c) of composite soft magnetic material (65) formed on both surfaces of said conductive support (75), said composite magnetic layer (65) having insulation, each of said composite magnetic layers (77a-c) comprising a composite magnetic material (65) which consists essentially of soft magnetic flakes (79) and a organic binder (81) and has electrical non-conductivity, and at least two magnetic resonances different from each other.

7. A printed circuit board as claimed in claim 6, wherein at least one of said layers (77b) has a dielectric layer (83) on the surface and/or at least one of said layers (77c) contains a dielectric powder (85).

8. A printed circuit board as claimed in claim 6 or 7, wherein said soft magnetic flakes consist of a mixture of at least two kind of soft magnetic flakes (79) having magnetic anisotropy different in strength from each other and said at least two kinds of soft magnetic flakes (79) are at least one flakes of Sendust, iron-nickel alloy, spinel type ferrite, and planner type ferrite.

9. An electronic apparatus (87) comprising a printed circuit board and an active element (35) mounted on said printed circuit board (21), said active element (35) radiating an inductive noise, said electronic apparatus (87) further comprising an insulating soft magnetic layer (89) formed around said active elements (35), said composite magnetic material layer (89) consisting essentially of soft magnetic flakes (79) and an organic binder (81), and having electrical non-conductivity and at least two magnetic resonances different from each other.

10. An electronic apparatus as claimed in claim 9, wherein said soft magnetic flakes (79) consist of a mixture of at least two kinds of soft magnetic flakes having magnetic anisotropy different in strength from each other, and said at least two kinds of soft magnetic flakes (79) are at least one flake of Sendust, iron-nickel alloy, spinel type ferrite, and plannar type ferrite.

11. An electronic apparatus as claimed in claim 9 or 10, wherein said composite magnetic material layer (89) is formed between said printed circuit board (21) and said active element (35), and/or said printed circuit board (21) has a plurality of conductive patterns (43, 45, 47), and/or said composite magnetic material layer (89) is formed inside a cover (53), said cover (53) covering said active element (40) together with said printed circuit board (21).

## Patentansprüche

1. Elektromagnetisches Interferenzunterdrückungsteil (61, 93) mit einem magnetischen Kompositwerkstoff (65),
wobei der magnetische Kompositwerkstoff (65) im wesentlichen aus weichmagnetischen Flocken (79) und einem organischen Binder (81) besteht,
der magnetische Kompositwerkstoff (65) elektrisch nicht-leitend ist und mindestens zwei magnetische Resonanzen in voneinander unterschiedlichen Frequenzbereichen aufweist.

2. Elektromagnetisches Interferenzunterdrückungsteil nach Anspruch 1, bei dem die mindestens zwei magnetischen Resonanzen in einem Frequenzbereich von 1 bis 2000 MHz dargestellt sind.

3. Elektromagnetisches Interferenzunterdrückungsteil nach Anspruch 2, bei dem die weichmagnetischen Flocken (79) eine Mischung vom mindestens zwei Arten von weichmagnetischen Flocken sind mit der Stärke von einander verschiedener Anisotropie, und jede der mindestens zwei Arten von weichmagnetischen Flocken (79) eine Oberflächenoxidschicht aufweist.

4. Verfahren des Herstellens eines magnetischen Kompositwerkstoffes (65) mit den Schritten des Mischens von mindestens zwei Arten von weichmagnetischen Flocken (79) mit voneinander in der Stärke verschiedener magnetischer Anisotropie und eines organischen Binders (81) und des Formens der Mischung zum Erzeugen des magnetischen Kompositwerkstoffes (65), der elektrisch nicht-leitend ist und mindestens zwei magnetische Resonanzen unterschiedlich voneinander aufweist.

5. Verfahren nach Anspruch 4, weiter mit einem Schritt des Oxidierens der weichmagnetischen Flocken (79) in einer Gasatmosphäre, die Sauerstoff enthält, durch die Benutzung eines Vorganges der langsamen Oxidation der Dampfphase vor oder während des Schrittes des Mischens der weichmagnetischen Flocken (79) mit dem organischen Binder (81), wobei bevorzugt jedes der weichmagnetischen Flockenpulver (79) eine Oberflächenoxidschicht aufweist.

6. Bedruckte Leiterplatte (21, 21a, 21b, 21c) mit einem bedruckten Verdrahtungssubstrat, Verdrahtungsleitern auf mindestens einer Oberfläche davon, einem leitenden Träger (75) und Schichten (77a, 77b, 77c) aus weichmagnetischem Kompositwerkstoff (65), der auf beiden Oberflächen des leitenden Trägers (75) gebildet ist,
wobei die magnetische Kompositschicht (65) eine Isolation aufweist, jede der magnetischen Kompositschichten (77a-c) einen magnetischen Kompositwerkstoff (65) aufweist, der im wesentlichen aus magnetischen Flocken (79) und einem organischen Binder besteht und elektrisch nicht-leitend ist und mindestens zwei magnetische Resonanzen unterschiedlich voneinander aufweist.

7. Bedruckte Leiterplatte nach Anspruch 6, bei der mindestens eine der Schichten (77b) eine dielektrische Schicht (83) auf der Oberfläche aufweist und/oder mindestens eine der Schichten (77c) ein dielektrisches Pulver (85) enthält.

8. Bedruckte Leiterplatte nach Anspruch 6 oder 7, bei der die weichmagnetischen Flocken aus einer Mischung von mindestens zwei Arten von weichmagnetischen Flocken (79) mit einer in der Stärke voneinander unterschiedlichen magnetischen Anisotropie bestehen und die mindestens zwei Arten von magnetischen Flocken (79) mindestens Flocken aus Sendust, Eisen-Nickel-Legierung, Ferrit des Spinel-Types und Ferrit des Plan-Types sind.

9. Elektronisches Gerät (87) mit einer bedruckten Leiterplatte und einem auf der bedruckten Leiterplatte (21) angebrachten aktiven Element (35), wobei das aktive Element (35) Induktionsrauschen strahlt, das elektronische Gerät (87) weiter eine isolierende weichmagnetische Schicht (89) aufweist, die um die aktiven Elemente (35) gebildet ist, die magnetische Kompositwerkstoffschicht (89) im wesentlichen aus weichmagnetischen Flocken (79) und einem organischen Binder (81) besteht und nicht-leitend ist und mindestens zwei magnetische Resonanzen unterschiedlich voneinander aufweist.

10. Elektronisches Gerät nach Anspruch 9, bei dem die weichmagnetischen Flocken (79) aus einer Mischung von mindestens zwei Arten von weichmagnetischen Flocken mit in der Stärke voneinander unterschiedlicher magnetischer Anisotropie bestehen und die mindestens zwei Arten von weichmagnetischen Flocken (79) mindestens eine Flocke aus Sendust, Eisen-Nickel-Legierung, Ferrit vom Spinel-Typ und Ferrit vom Planar-Typ sind.

11. Elektronisches Gerät nach Anspruch 9 oder 10, bei dem die magnetische Kompositwerkstoffschicht (89) zwischen der bedruckten Leiterplatte (21) und dem aktiven Element (35) gebildet ist und/oder die bedruckte Leiterplatte eine Mehrzahl von leitenden Mustern (43, 45, 47) aufweist und/oder die magnetische Kompositwerkstoffschicht (89) innerhalb einer Abdeckung (53) gebildet ist, wobei die Abdeckung (53) das aktive Element (40) zusammen mit der bedruckten Leiterplatte (21) abdeckt.

## Revendications

1. Elément suppresseur d'interférences électromagnétiques (61, 93) comprenant un matériau magnétique composite (65) ce matériau magnétique composite (65) étant constitué essentiellement de paillettes magnétiques douces (79) et d'un liant organique (81), ce matériau magnétique composite (65) présentant une non-conductivité électrique et comportant au moins deux résonances magnétiques dans des zones de fréquence différentes l'une de l'autre.

2. Elément suppresseur d'interférences électromagnétiques selon la revendications 1,
dans lequel
au moins deux résonances magnétiques se manifestent dans une zone de fréquences de 1 à 2 000 MHz.

3. Elément suppresseur d'interférences électromagnétiques selon la revendication 2,
dans lequel
les paillettes magnétiques douces (79) consistent en un mélange d'au moins deux types de paillettes magnétiques douces présentant des anisotropies de forces différentes l'une de l'autre, et chacun de ces deux types au moins de paillettes magnétiques douces (79) comporte une couche d'oxyde de surface.

4. Procédé de fabrication d'un matériau magnétique composite (65),
comprenant les étapes consistant à :
- mélanger au moins deux types de paillettes magnétiques douces (79) ayant des anisotropies de forces différentes l'une de l'autre, avec un liant organique (81), et
- mettre en forme le mélange pour produire le matériau magnétique composite (65) qui est électriquement non conducteur et présente au moins deux résonances magnétiques différentes l'une de l'autre.

5. Procédé selon la revendication 4,
comprenant en outre
une étape d'oxydation des paillettes magnétiques douces (79) dans une atmosphère gazeuse contenant de l'oxygène, par l'utilisation d'un processus d'oxydation lente en phase vapeur avant ou pendant l'étape de mélange des paillettes magnétiques douces (79) avec le liant organique (81), chacune des poudres de paillettes magnétiques douces (79) ayant de préférence une couche d'oxyde de surface.

6. Carte de circuit imprimé (21, 21a, 21b, 21c),
comprenant
un substrat de câblage imprimé, des conducteurs de câblage sur l'une au moins de ses surfaces, un support conducteur (75) et des couches (77a, 77b, 77c) de matériau magnétique doux composite (65) formées sur les deux surfaces du support conducteur (75), la couche magnétique composite (65) ayant une isolation, chacune des couches magnétiques composites (77a-77c) comprenant un matériau magnétique composite (65) constitué essentiellement de paillettes magnétiques douces (79) et d'un liant organique (81), et présentant une non-conductivité électrique ainsi qu'au moins deux résonances magnétiques différentes l'une de l'autre.

7. Carte de circuit imprimé selon la revendication 6,
dans laquelle
l'une au moins des couches (77b) comporte une couche diélectrique sur la surface, et/ou l'une au moins des couches (77c) contient une poudre diélectrique (85).

8. Carte de circuit imprimé selon la revendication 6 ou 7,
dans laquelle
les paillettes magnétiques douces consistent en un mélange d'au moins deux types de paillettes magnétiques douces (79) ayant des anisotropies magnétiques de forces différentes l'une de l'autre, et les deux types au moins de paillettes magnétiques douces (79) sont constitués de l'une au moins de paillettes de Sendust, d'alliage de fer-nickel, de ferrite de type spinelle, et de ferrite de type plannar.

9. Appareil électronique (87),
comprenant
une carte de circuit imprimé et un élément actif (35) monté sur la carte de circuit imprimé (21), l'élément actif (35) rayonnant un bruit inductif, l'appareil électronique (87) comprenant en outre une couche magnétique douce isolante (89) formée autour des éléments actifs (35), la couche de matériau magnétique composite (89) étant constituée essentiellement de paillettes magnétiques douces (79) et d'un liant organique (81), et présentant une non-conductivité électrique ainsi qu'au moins deux résonances magnétiques différentes l'une de l'autre.

10. Appareil électromagnétique selon la revendication 9,
dans lequel
les paillettes magnétiques douces (79) consistent en un mélange d'au moins deux types de paillettes magnétiques douces ayant des anisotropies magnétiques de forces différentes l'une de l'autre, et ces deux types au moins de paillettes magnétiques douces (79) consistent en l'une au moins de paillettes de Sendust, d'alliage de fer-nickel, de ferrite de type spinelle et de ferrite de type plannar.

11. Appareil électronique selon la revendication 9 ou 10,
dans lequel
la couche de matériau magnétique composite (89) est formée entre la carte de circuit imprimé (21) et l'élément actif (35), et/ou la carte de circuit imprimé (21) comporte une pluralité de motifs conducteurs (43, 45, 47), et/ou la couche de matériau magnétique composite (89) est formée à l'intérieur d'une plaque de couverture (53), cette plaque de couverture (53) recouvrant l'élément actif (40) en même temps que la carte de circuit imprimé (21).
